# DEMANDE DE BREVET EUROPEEN

(11) **EP 2 605 366 A1**
(43) Date de publication de la demande: **19.06.2013**
(21) Numéro de dépôt: 12197029.7
(22) Date de dépôt: 13.12.2012
(51) Int. Cl.: H02J 7/35

(54) **Système de génération et de stockage d'énergie électrique et appareil de télémesure**

(30) Priorité: 13.12.2011 FR 1161581
(71) Demandeur: Intesens, 31650 Saint-Orens-de-Gameville (FR)
(72) Inventeur: LAFONTAN, Xavier, 31650 SAINT-ORENS-DE-GAMEVILLE (FR); DE ROLLAND, Daniel, 31400 TOULOUSE (FR); TOULON-MEEKHUN, Dariga, 31400 TOULOUSE (FR)
(74) Mandataire: Ribeiro Dias, Alexandre

(57) **Abrégé**

La présente invention concerne un système de génération et de stockage d'énergie électrique comportant un générateur (10) d'énergie électrique, un dispositif de stockage (30) d'énergie électrique, et un dispositif de transfert (20) d'énergie électrique intercalé entre le générateur (10) et le dispositif de stockage (30). Ledit dispositif de transfert comporte un accumulateur intermédiaire (23) connecté directement au générateur (10) et adapté à stocker de l'énergie électrique reçue dudit générateur, des moyens de connexion (24) adaptés à être placés dans au moins deux états : un état connecté dans lequel l'accumulateur intermédiaire (23) se décharge vers le dispositif de stockage (30), et un état déconnecté dans lequel l'accumulateur intermédiaire (23) ne se décharge pas vers ledit dispositif de stockage (30), et un module de commande (25) configuré pour commander le passage des moyens de connexion (24) dans l'état connecté ou dans l'état déconnecté en fonction de la valeur d'une tension électrique (V_{PV}) sur le port d'entrée (21). La présente invention concerne également un appareil de télémesure.

## Description

### DOMAINE TECHNIQUE

La présente invention appartient au domaine de la génération et du stockage d'énergie électrique. Plus particulièrement, la présente invention concerne un dispositif de transfert d'énergie électrique entre un générateur d'énergie électrique et un dispositif de stockage, un système de génération et de stockage d'énergie électrique et un appareil de télémesure.

### ÉTAT DE LA TECHNIQUE

Une application préférée de l'invention, bien que nullement limitative, concerne les appareils de télémesure. De tels appareils de télémesure sont placés à un endroit où une mesure doit être effectuée, et transmettent des informations relatives aux mesures effectuées à un serveur distant.

Un tel appareil de télémesure comporte donc au moins un capteur adapté à mesurer une grandeur physique prédéfinie locale (température, pression, amplitude/fréquence d'ondes mécaniques, etc.), ainsi que des moyens de communication adaptés à transmettre lesdites informations relatives aux mesures effectuées au serveur distant, lesdits moyens de communication pouvant être des moyens filaires et/ou non filaires.

De nombreuses applications nécessitent de déployer de tels appareils de télémesure dans des endroits non desservis par un réseau de distribution d'énergie électrique. Dans ce cas, de tels appareils de télémesure doivent en outre être autonomes en énergie électrique, et comportent à cet effet un générateur d'énergie électrique, consistant par exemple en un ou plusieurs panneaux solaires, et un dispositif de stockage d'énergie électrique.

Les caractéristiques courant/tension d'un panneau solaire sont telles que la puissance électrique fournie croît progressivement avec la tension aux bornes dudit panneau solaire, jusqu'à atteindre une puissance électrique maximale, et décroît ensuite rapidement jusqu'à atteindre une puissance électrique nulle (du fait que le courant électrique fourni est alors nul). De manière générale, la valeur de la tension pour laquelle la puissance électrique est atteinte varie peu avec l'ensoleillement. Par contre, la valeur de la puissance électrique maximale dépend fortement de l'ensoleillement.

Pour des appareils de télémesure, il n'est généralement possible ni d'avoir des panneaux solaires de grandes dimensions ni d'avoir des mécanismes permettant d'orienter de façon optimale lesdits panneaux solaires par rapport au Soleil. En général, les panneaux solaires et le dispositif de stockage, généralement reliés par un régulateur de tension, sont choisis et agencés de sorte à assurer une charge efficace du dispositif de stockage en conditions d'ensoleillement fort. Par contre, l'énergie électrique générée en conditions d'ensoleillement faible ne permet alors généralement pas de charger le dispositif de stockage.

On connaît également des dispositifs, dits « MPPT » pour « Maximum Power Point Tracking », visant à forcer les panneaux solaires à fonctionner autour de leur point de fonctionnement optimal d'un point de vue puissance électrique fournie. Toutefois, les dispositifs MPPT connus sont généralement trop complexes et/ou peu adaptés aux niveaux de puissance électrique considérés pour l'alimentation d'un appareil de télémesure.

### EXPOSÉ DE L'INVENTION

La présente invention vise à fournir une solution permettant de charger un dispositif de stockage même lorsque l'énergie électrique générée est faible, par exemple dans des conditions d'ensoleillement faible dans le cas d'un panneau solaire. En outre, la présente invention vise à proposer une solution qui permette d'optimiser la puissance électrique fournie de façon simple, robuste, et peu coûteuse à fabriquer.

Selon un premier aspect, l'invention concerne un système de génération et de stockage d'énergie électrique comportant un générateur d'énergie électrique, un dispositif de stockage d'énergie électrique, et un dispositif de transfert d'énergie électrique intercalé entre le générateur et le dispositif de stockage. En outre, ledit dispositif de transfert comporte :
- un accumulateur intermédiaire connecté directement au générateur et adapté à stocker de l'énergie électrique reçue dudit générateur,
- des moyens de connexion adaptés à être placés dans au moins deux états : un état connecté dans lequel l'accumulateur intermédiaire se décharge vers le dispositif de stockage, et un état déconnecté dans lequel l'accumulateur intermédiaire ne se décharge pas vers ledit dispositif de stockage,
- un module de commande configuré pour placer les moyens de connexion dans l'état connecté lorsque la valeur absolue d'une tension électrique aux bornes du générateur atteint une valeur limite supérieure prédéfinie, et pour placer les moyens de connexion dans l'état déconnecté lorsque la valeur absolue de la tension électrique aux bornes dudit générateur atteint une valeur limite inférieure prédéfinie.

Par « connecté », on entend une liaison électrique permettant le transfert d'énergie électrique entre les deux composants électriques connectés. Ce transfert d'énergie électrique peut se faire soit directement soit par l'intermédiaire d'autres composants électriques.

Par « connecté directement », on entend qu'aucun composant électrique n'est intercalé entre les deux composants électriques connectés directement, ou que lesdits deux composants électriques connectés directement sont séparés par une ou plusieurs diodes agencées de sorte à ne permettre les transferts d'énergie électrique que dans un sens entre lesdits deux composants électriques connectés directement.

Du fait que l'accumulateur intermédiaire est connecté directement au générateur d'énergie électrique, il va pouvoir accumuler progressivement toute l'énergie électrique fournie par ledit générateur, même lorsque celle-ci est générée en faible quantité.

En outre, l'accumulateur intermédiaire, tel qu'un condensateur et/ou un super-condensateur, va voir la tension électrique à ses bornes augmenter progressivement à mesure qu'il accumule l'énergie électrique reçue du générateur d'énergie électrique. Du fait que l'accumulateur intermédiaire est connecté directement aux bornes dudit générateur, la tension électrique aux bornes dudit générateur va suivre sensiblement celle aux bornes de dudit accumulateur intermédiaire. De la sorte, il sera possible de contrôler la tension électrique aux bornes du générateur d'énergie électrique. Il sera en particulier possible de faire fonctionner ledit générateur avec une tension électrique à ses bornes comprise entre la valeur limite inférieure et la valeur limite supérieure.

Suivant des modes particuliers de réalisation, le système de génération et de transfert d'énergie électrique comporte l'une ou plusieurs des caractéristiques suivantes, prises isolément ou suivant toutes les combinaisons techniquement possibles.

Dans un mode particulier de réalisation, le générateur d'énergie électrique étant du type fournissant, pour un ensemble prédéfini de conditions de fonctionnement dudit générateur, une puissance électrique qui croît avec la tension électrique aux bornes dudit générateur jusqu'à atteindre une valeur maximale, puis décroît jusqu'à atteindre une valeur nulle, la valeur limite supérieure et la valeur limite inférieure sont telles que la puissance électrique fournie par le générateur est proche de la puissance électrique maximale pour chacune des conditions de fonctionnement dudit ensemble prédéfini de conditions de fonctionnement.

Un tel choix préalable des valeurs limite supérieure et inférieure permet d'assurer de façon simple que le générateur d'énergie électrique fonctionne avec une tension électrique à ses bornes qui lui permet de fournir un bon niveau de puissance électrique quelles que soient les conditions de fonctionnement considérées.

Dans un mode particulier de réalisation, l'ensemble prédéfini de conditions de fonctionnement comportant des conditions de fonctionnement défavorables et des conditions de fonctionnement favorables en termes de puissance électrique fournie par ledit générateur, la puissance électrique maximale pour les conditions de fonctionnement défavorables est obtenue pour une valeur de la tension électrique, aux bornes dudit générateur, comprise entre la valeur limite supérieure et la valeur limite inférieure.

La puissance électrique fournie par le générateur dans des conditions de fonctionnement défavorables est inférieure à celle fournie dans des conditions de fonctionnement favorables. Ainsi, pour de telles conditions de fonctionnement défavorables, il est important de forcer le générateur d'énergie électrique à fournir une puissance électrique proche de la puissance électrique maximale qu'il peut fournir, ce qui est rendu possible de façon simple par un tel choix préalable des valeurs limite supérieure et inférieure.

Dans un mode particulier de réalisation, le module de commande comporte un circuit suiveur à amplificateur opérationnel et un circuit comparateur à deux seuils à amplificateur opérationnel, lesdits deux seuils correspondant respectivement à la valeur limite supérieure et à la valeur limite inférieure.

Dans un mode particulier de réalisation, l'accumulateur intermédiaire comporte un condensateur et/ou un super-condensateur connecté.

Dans un mode particulier de réalisation, le système de génération et de transfert comporte un premier régulateur de tension adapté à appliquer une tension de valeur sensiblement constante aux bornes du dispositif de stockage lorsque les moyens de connexion sont dans l'état connecté.

Dans un mode particulier de réalisation, les moyens de connexion comportent le premier régulateur de tension, le module commande activant ledit premier régulateur de tension pour placer les moyens de connexion dans l'état connecté, et désactivant ledit premier régulateur de tension pour placer lesdits moyens de connexion dans l'état déconnecté.

Dans un mode particulier de réalisation, le système de génération et de transfert comporte un second régulateur de tension dont l'entrée est couplée au port d'entrée, et dont la sortie est couplée à un port d'alimentation du module de commande.

Dans un mode particulier de réalisation, le générateur d'énergie électrique comporte un panneau solaire et/ou un générateur thermoélectrique tel qu'un module Seebeck.

Selon un second aspect, l'invention concerne un appareil de télémesure comportant un ou plusieurs capteurs adaptés à mesurer la valeur d'une grandeur physique prédéfinie et des moyens de communiquer des informations relatives aux mesures effectuées à un serveur distant. En outre, l'appareil de télémesure comporte un système de génération et de stockage d'énergie électrique conforme à l'un quelconque des modes de réalisation de l'invention.

### PRÉSENTATION DES FIGURES

L'invention sera mieux comprise à la lecture de la description suivante, donnée à titre d'exemple nullement limitatif, et faite en se référant aux figures qui représentent :
- Figure 1 : une représentation schématique d'un système de génération et de stockage d'énergie électrique selon l'invention,
- Figures 2a et 2b : des exemples illustrant l'évolution de la puissance électrique fournie par un panneau solaire en fonction de la tension électrique aux bornes de ce panneau solaire, pour différentes conditions d'ensoleillement et différentes températures,

- Figure 3 : une représentation schématique d'un mode préféré de réalisation d'un dispositif de transfert d'énergie électrique selon l'invention,
- Figure 4 : une représentation schématique d'un mode préféré de réalisation d'un module de commande d'un dispositif de transfert d'énergie électrique selon l'invention,
- Figure 5 : un exemple illustrant la tension de charge fournie par un dispositif de transfert d'énergie électrique selon l'invention à un dispositif de stockage d'énergie électrique,
- Figure 6 : un exemple illustrant les performances obtenues par un système de génération et de stockage d'énergie électrique selon l'invention par rapport à un système selon l'art antérieur.

### DESCRIPTION DÉTAILLÉE DE L'INVENTION

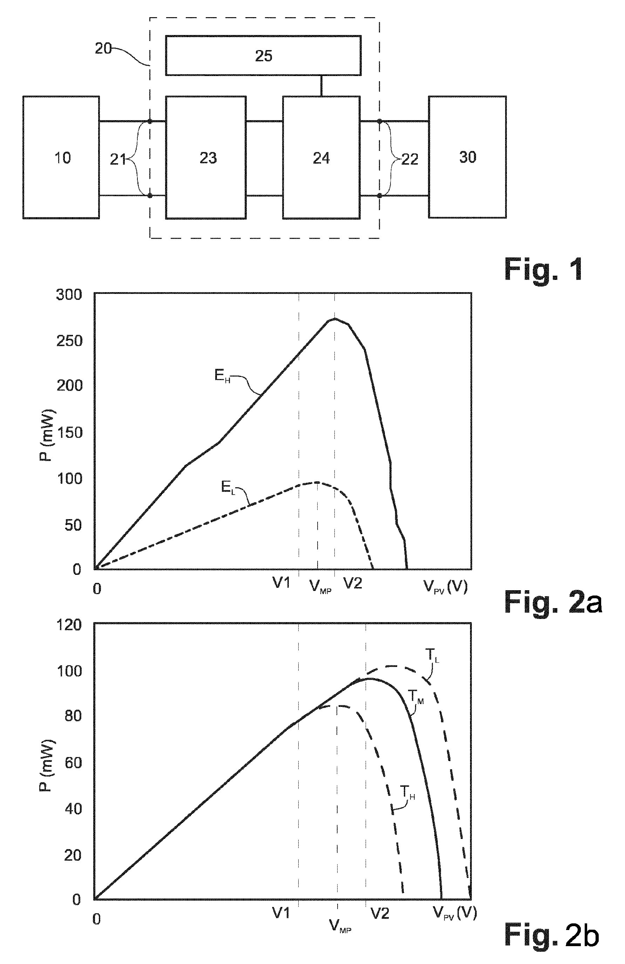

La figure 1 représente de façon très schématique un système de génération et de stockage d'énergie électrique selon l'invention.

Tel qu'illustré par la figure 1, le système de génération et de stockage d'énergie électrique comporte principalement un générateur 10 électrique, adapté à générer de l'énergie électrique, et un dispositif de stockage 30 d'énergie électrique, ainsi qu'un dispositif de transfert 20 d'énergie électrique intercalé entre ledit générateur électrique et ledit dispositif de stockage.

Le générateur 10 électrique peut être de tout type connu en soi, et peut comporter notamment un ou plusieurs panneaux solaires, et/ou un ou plusieurs générateurs thermoélectriques tels que des modules Seebeck, etc.

Le dispositif de stockage 30 peut être tout type d'accumulateur électrique connu en soi, adapté à stocker temporairement de l'énergie électrique en vue de la restituer ultérieurement, tel qu'un accumulateur nickel-métal hydrure (Ni-MH), un accumulateur lithium, etc.

Le dispositif de transfert 20 d'énergie électrique comporte un port d'entrée 21 connecté au générateur 10 électrique, et un port de sortie 22 connecté au dispositif de stockage 30.

Le dispositif de transfert 20 d'énergie électrique comporte au moins :
- un accumulateur intermédiaire 23,
- des moyens de connexion 24,
- un module de commande 25.

L'accumulateur intermédiaire 23 est connecté au port d'entrée 21 et est adapté à stocker temporairement de l'énergie électrique générée par le générateur 10 électrique.

De préférence, l'accumulateur intermédiaire 23 est formé par un ou plusieurs condensateurs et/ou un ou plusieurs super-condensateurs. Dans la suite de la description, on se place de manière nullement limitative dans le cas où l'accumulateur intermédiaire 23 est constitué par un condensateur 230.

Les moyens de connexion 24 sont adaptés à être placés dans au moins deux états : un premier état, dit « état connecté », et un second état, dit « état déconnecté ».

Lorsque les moyens de connexion 24 sont placés dans l'état connecté, l'accumulateur intermédiaire 23 est connecté au port de sortie et peut se décharger vers ledit port de sortie 22 par l'intermédiaire desdits moyens de connexion, et transférer de l'énergie électrique au dispositif de stockage 30.

Lorsque les moyens de connexion 24 sont placés dans l'état déconnecté, l'accumulateur intermédiaire 23 est déconnecté du port de sortie 22 et ne peut théoriquement pas se décharger vers ledit port de sortie de sorte que l'énergie électrique stockée n'est pas transférée dudit accumulateur intermédiaire 23 vers le dispositif de stockage 30, à d'éventuels courants de fuite près. En d'autres termes, les moyens de connexion 24, lorsqu'ils sont dans l'état déconnecté, présentent à l'accumulateur intermédiaire 23 une impédance suffisamment élevée pour que ledit accumulateur intermédiaire 23 ne se décharge sensiblement pas.

De tels moyens de connexion 24 présentent donc une fonction minimale comparable à celle d'un commutateur adapté à être placé dans un état fermé (état connecté des moyens de connexion 24) et dans un état ouvert (état déconnecté des moyens de connexion 24). Dans un mode particulièrement simple de réalisation, lesdits moyens de connexion peuvent consister en un tel commutateur.

Le module de commande 25 est configuré pour commander le passage des moyens de connexion 24 de l'état connecté à l'état déconnecté, et de l'état déconnecté à l'état connecté. Ces changements d'état des moyens de connexion 24 sont commandés en fonction de la valeur d'une grandeur électrique sur le port d'entrée 21, de préférence la valeur de la tension sur ledit port d'entrée 21.

Dans la suite de la description, on se place de manière nullement limitative dans le cas où le générateur 10 électrique est un panneau solaire, par exemple constitué de cellules photovoltaïques à base de silicium monocristallin, de silicium poly-cristallin, ou de silicium amorphe.

La figure 2a représente de façon schématique l'évolution générale de la puissance électrique (P, exprimée en mW) fournie par un tel panneau solaire en fonction de la tension (V_{PV}) aux bornes de ce panneau solaire. Plus particulièrement deux courbes sont représentées sur la figure 2a : une première courbe E_{H} (en trait continu) obtenue en simulant un ensoleillement fort au moyen d'une source de lumière artificielle, et une seconde courbe E_{L} (en traits discontinus) obtenue en simulant un ensoleillement faible. La première courbe E_{H} et la seconde courbe E_{L} ont été obtenues à la même température, en l'occurrence une température du panneau solaire d'environ 44 degrés Celsius (°C) (température ambiante d'environ 32°C).

Tel qu'illustré par la figure 2a, et quelles que soient les conditions d'ensoleillement, la puissance électrique fournie par le panneau solaire 10 croît lentement avec la tension V_{PV} jusqu'à atteindre une valeur maximale, puis décroît rapidement jusqu'à atteindre une valeur nulle lorsque le courant est nul.

On comprend que, sur la base des courbes représentant l'évolution de la puissance maximale fournie par un panneau solaire 10 en fonction de la tension V_{PV} aux bornes de ce panneau solaire, il est possible de déterminer une plage de valeurs de la tension V_{PV} dans laquelle la puissance électrique fournie par le panneau solaire 10 sera proche de la puissance électrique maximale quelles que soient les conditions d'ensoleillement.

Par exemple, on peut déterminer des conditions minimales d'ensoleillement, à partir desquelles la valeur de la tension pour laquelle la puissance électrique maximale est fournie varie peu avec l'ensoleillement, et pour lesquelles on souhaite optimiser la puissance électrique fournie par le panneau solaire 10. Pour ces conditions minimales d'ensoleillement, on peut alors choisir une plage de valeurs autour de la valeur (désignée par V_{MP} sur la figure 2a) de la tension pour laquelle la puissance électrique maximale est obtenue. Du fait que la puissance électrique augmente lentement avec la tension avant d'atteindre la puissance électrique maximale, la valeur de la tension pour laquelle cette puissance électrique maximale est obtenue augmentant avec l'ensoleillement, on assure que la puissance électrique fournie sera proche de la puissance électrique maximale dès lors que les conditions d'ensoleillement seront meilleures que les conditions minimales d'ensoleillement précitées.

Un exemple de plage de valeurs permettant, dans l'exemple illustré par la figure 2a, d'assurer que la puissance électrique fournie est toujours proche de la puissance électrique maximale compte tenu des conditions d'ensoleillement, est représenté sur ladite figure 2a et s'étend entre une valeur limite inférieure V1 et une valeur limite supérieure V2.

La figure 2b représente de façon schématique l'évolution générale de la puissance électrique fournie par le panneau solaire 10 en fonction de la tension aux bornes dudit panneau solaire, mais pour un ensoleillement faible (mêmes conditions d'ensoleillement que pour la courbe E_{L} de la figure 2a) et plusieurs températures différentes.

Plus particulièrement, trois courbes sont représentées sur la figure 2b :
- une première courbe T_{H} (la plus à gauche de la figure, en traits discontinus) obtenue pour une température du panneau solaire d'environ 68°C (température ambiante 42°C),
- une seconde courbe T_{M} (en trait continu) obtenue pour une température du panneau solaire d'environ 44°C (température ambiante 32°C, correspondant à la courbe E_{L} de la figure 2a),
- une troisième courbe T_{L} (la plus à droite de la figure, en traits discontinus) obtenue pour une température du panneau solaire d'environ 31°C (température ambiante 25°C).

Comme précédemment, la puissance électrique fournie par le panneau solaire 10 croît lentement avec la tension V_{PV} jusqu'à atteindre une valeur maximale, puis décroît rapidement jusqu'à atteindre une valeur nulle lorsque le courant est nul (la tension étant alors couramment désignée par tension de circuit ouvert).

On constate sur la figure 2b que la valeur de la tension pour laquelle la puissance électrique maximale est fournie varie sensiblement avec la température. En outre, plus la température du panneau solaire 10 est élevée, et plus les valeurs de la puissance électrique maximale et de la tension de circuit ouvert sont faibles.

La valeur limite inférieure V1 et la valeur limite supérieure V2 peuvent être choisies en tenant compte de la température du panneau solaire 10.

Suivant un exemple non limitatif, la valeur limite inférieure V1 et la valeur limite supérieure V2 sont choisies d'après une courbe, représentant l'évolution de la puissance électrique en fonction de la tension V_{PV}, correspondant aux conditions les plus défavorables d'ensoleillement et de température pour lesquelles on souhaite optimiser la puissance électrique fournie par le panneau solaire 10.

Sur la figure 2b, on se base par exemple sur la courbe T_{H}. De manière générale, plus l'ensoleillement est faible, plus la température ambiante est faible. On comprend donc que la courbe T_{H} correspond à des conditions défavorables dans la mesure où la probabilité d'avoir à la fois un ensoleillement faible et une température ambiante élevée, de l'ordre de 42°C, est faible.

La figure 2b représente un exemple de valeur limite inférieure V1 et de valeur limite supérieure V2. Dans cet exemple, la valeur limite supérieure V2 est choisie inférieure à la valeur de la tension de court circuit de la courbe T_{H}, afin d'assurer que ladite valeur limite supérieure V2 puisse être atteinte dans les conditions d'ensoleillement et de température de la courbe T_{H}. La valeur limite supérieure V2 est en outre choisie supérieure à la valeur V_{MP} de la tension pour laquelle la puissance électrique maximale est obtenue, tandis que la valeur limite inférieure V1 est choisie inférieure à ladite valeur V_{MP}, afin d'assurer que ladite puissance électrique maximale puisse être fournie dans les conditions d'ensoleillement et de température de la courbe T_{H}.

Ainsi, on assure que la puissance électrique fournie est toujours proche de la puissance électrique maximale dans les conditions de fonctionnement défavorables considérées. Si les conditions de fonctionnement du panneau solaire 10 sont plus favorables, on constate à la lecture des figures 2a et 2b que la puissance électrique fournie sera dans tous les cas supérieure à celle fournie dans les conditions de fonctionnement défavorables pour lesquelles la courbe T_{H} a été obtenue.

Dans un mode préféré de réalisation, le module de commande 25 est par exemple configuré pour :
- placer les moyens de connexion 24 dans l'état connecté lorsque la valeur absolue de la tension V_{PV}, après avoir augmenté progressivement, atteint la valeur limite supérieure V2,
- placer les moyens de connexion 24 dans l'état déconnecté lorsque la valeur absolue de la tension V_{PV}, après avoir diminué progressivement, atteint la valeur limite inférieure V1.

Combiné au condensateur 230 et aux moyens de connexion 24, un tel module de commande 25 permet de forcer le panneau solaire 10 à fonctionner dans la plage de valeurs de la tension V_{PV} définie par la valeur limite inférieure V1 et par la valeur limite supérieure V2, de sorte que la puissance électrique fournie est optimisée pour une large gamme de conditions d'ensoleillement.

En effet, tant que les moyens de connexion 24 sont dans l'état déconnecté, le condensateur 230 va être chargé par le panneau solaire 10. Même avec un ensoleillement faible, l'énergie électrique générée va contribuer à charger ledit condensateur 230, qui ne peut pas se décharger vers le port de sortie 22. A mesure que le condensateur 230 se charge, la tension à ses bornes augmente. Comme le condensateur 230 est connecté au port d'entrée 21, en parallèle avec le panneau solaire, la tension V_{PV} augmente également. Ainsi la tension V_{PV} va augmenter progressivement, même avec un ensoleillement faible, jusqu'à atteindre la valeur limite supérieure V2. Le module de commande 25 va alors placer les moyens de connexion 24 dans l'état connecté, de sorte que le condensateur 230 va se décharger vers le port de sortie 22 et le dispositif de stockage 30. La tension aux bornes du condensateur 230, du fait de cette décharge, diminue également, de même que la tension V_{PV} aux bornes du panneau solaire 10. La tension V_{PV} va alors diminuer jusqu'à atteindre la valeur limite inférieure V1. Le module de commande 25 va alors placer les moyens de connexion 24 dans l'état déconnecté, de sorte que le condensateur 230 ne va plus se décharger par l'intermédiaire des moyens de connexion 24, et va se charger à nouveau progressivement, etc.

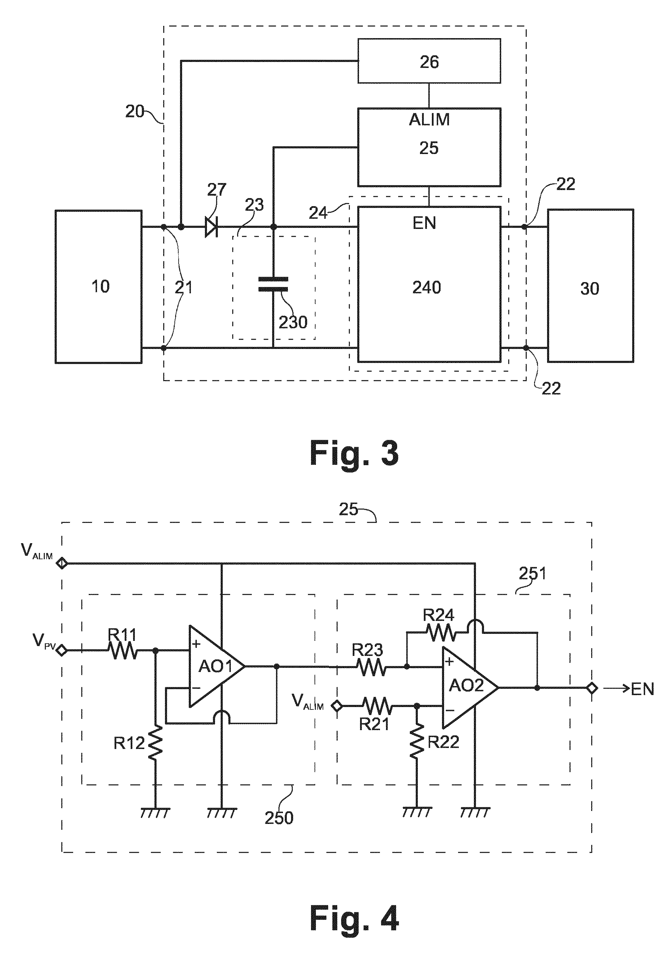

La figure 3 représente schématiquement un mode préféré de réalisation du dispositif de transfert 20 d'énergie électrique.

Dans ce mode de réalisation, l'accumulateur intermédiaire 23 est un condensateur 230 (ou un super-condensateur), et le dispositif de transfert 20 d'énergie électrique comporte une diode 27 agencée de sorte à empêcher ledit condensateur 230 de se décharger vers le panneau solaire 10, tant que les moyens de connexion 24 se trouvent dans l'état déconnecté.

Dans ce mode de réalisation, le dispositif de transfert 20 d'énergie électrique comporte en outre un premier régulateur de tension 240 dont la sortie est connectée au port de sortie 22.

De manière générale, l'utilisation du premier régulateur de tension 240 permet d'appliquer une tension sensiblement constante sur le port de sortie 22 lorsque les moyens de connexion sont dans l'état connecté, de valeur adaptée à permettre de charger le dispositif de stockage 30.

En outre, le premier régulateur de tension 240 permet d'adapter les niveaux de tension fournis par le panneau solaire 10 aux niveaux de tension attendus par le dispositif de stockage 30. Si les niveaux de tension fournis par le panneau solaire 10 sont inférieurs aux niveaux de tension attendus par le dispositif de stockage 30, le premier régulateur de tension 240 est par exemple une alimentation à découpage de type « Boost ». Si les niveaux de tension fournis par le panneau solaire 10 sont supérieurs aux niveaux de tension attendus par le dispositif de stockage 30, le premier régulateur de tension 240 est par exemple une alimentation à découpage de type « Buck ». De tels régulateurs de tension sont considérés comme connus de l'homme de l'art.

Dans le mode préféré de réalisation illustré par la figure 3, l'entrée du premier régulateur de tension 240 est connectée au condensateur 230, et le module de commande 25 est connecté à un port d'activation EN du premier régulateur de tension 240.

Ainsi, le premier régulateur de tension 240 contribue également avantageusement à assurer les fonctions des moyens de connexion 24. En effet, pour placer les moyens de connexion 24 dans l'état connecté, le module de commande 25 activera le premier régulateur de tension 240 par l'intermédiaire du port d'activation EN. Le premier régulateur de tension 240 présentera alors une impédance d'entrée suffisamment élevée pour éviter que le condensateur 230 ne se décharge. Pour placer les moyens de connexion 24 dans l'état déconnecté, le module de commande 25 désactivera le premier régulateur de tension 240 par l'intermédiaire du port d'activation EN. Le premier régulateur de tension 240 présentera alors une impédance d'entrée permettant au condensateur 230 de se décharger par son intermédiaire.

Du fait que le premier régulateur de tension 240 assure les fonctions des moyens de connexion 24, les moyens de connexion 24 peuvent être fabriqués sans ajouter de composants électriques par rapport aux solutions de l'art antérieur.

Dans le mode préféré de réalisation illustré par la figure 3, le dispositif de transfert 20 d'énergie électrique comporte en outre un second régulateur de tension 26, dont l'entrée est par exemple couplée au port d'entrée 21, et dont la sortie est couplée à un port d'alimentation ALIM du module de commande 25.

De manière connue en soi, le second régulateur de tension 26 vise à appliquer une tension d'alimentation de valeur sensiblement constante au module de commande 25.

La figure 4 représente un mode préféré de réalisation du module de commande 25.

Dans ce mode de réalisation, le module de commande 25 comporte principalement un circuit suiveur 250 et circuit comparateur 251 à deux seuils, tous deux de type connu en soi et à base d'amplificateurs opérationnels. Les deux seuils du circuit comparateur 251 correspondent respectivement à la valeur limite inférieure V1 et à la valeur limite supérieure V2.

Le circuit suiveur 250 comporte principalement un amplificateur opérationnel AO1 ainsi que deux résistances R11 et R12 dont les valeurs permettent d'adapter les niveaux de tension du panneau solaire 10 aux niveaux de tension attendus par le circuit comparateur 251 à deux seuils (qui dépendent notamment de la valeur de la tension fournie par le second régulateur de tension 26). La détermination de valeurs adaptées pour les résistances R11 et R12 est considérée comme à la portée de l'homme de l'art.

L'intérêt de ce circuit suiveur 250 réside dans son impédance d'entrée élevée adaptée à empêcher que le condensateur 230 ne se décharge par l'intermédiaire du module de commande 25.

Le circuit comparateur 251 à deux seuils (sans inversion dans l'exemple illustré) comporte principalement un amplificateur opérationnel A02, ainsi que deux paires de résistances :
- une paire de résistances R21 et R22 dont les valeurs permettent de fixer une valeur d'une tension de référence,
- une paire de résistances R23 et R24 dont les valeurs permettent de fixer les valeurs des seuils (associées respectivement à la valeur limite inférieure V1 et à la valeur limite supérieure V2).

La détermination de valeurs adaptées pour les résistances R21, R22, R23 et R24 est considérée comme à la portée de l'homme de l'art.

Le module de commande 25 illustré par la figure 4 est donc tout à fait avantageux en ce qu'il est particulièrement simple (en particulier il comporte peu de composants électriques), robuste et peu coûteux à fabriquer.

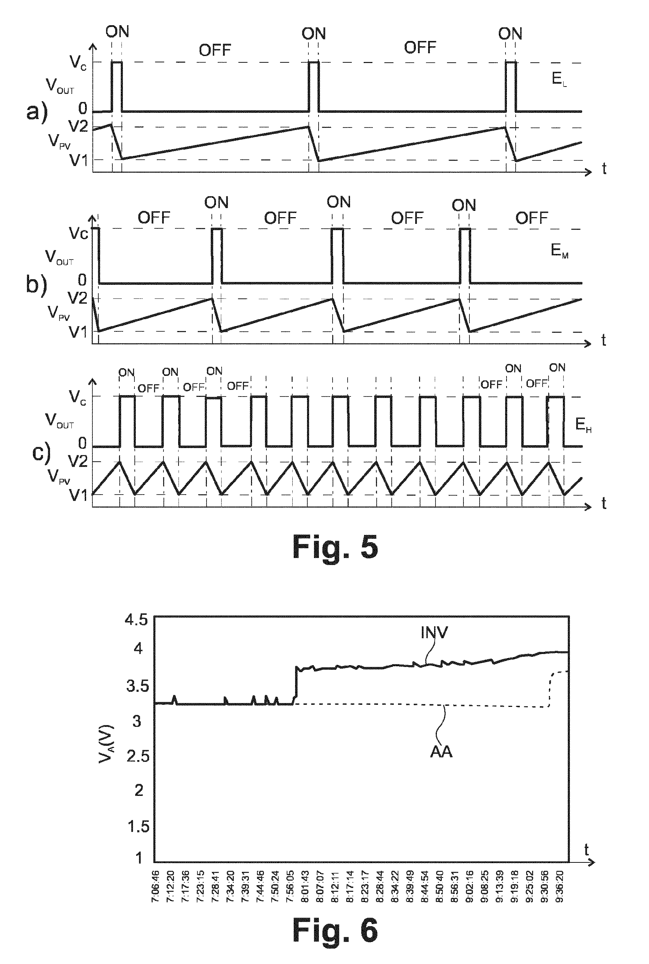

La figure 5 représente schématiquement l'évolution au cours du temps (désigné par « t » dans cette figure) de la tension V_{PV} sur le port d'entrée 21 et de la tension de charge, désignée par V_{OUT}, appliquée par le premier régulateur de tension 240 sur le port de sortie 22 du dispositif de transfert 20 d'énergie électrique. Lorsque le premier régulateur de tension 240 est activé, il délivre une tension de charge sensiblement constante de valeur V_{C}, et lorsque ledit premier régulateur de tension est désactivé, il délivre une tension de valeur sensiblement nulle.

La figure 5 comporte plus particulièrement trois parties a), b) et c) représentant la tension V_{PV} et la tension de charge V_{OUT} pour trois conditions d'ensoleillement différentes, respectivement un ensoleillement faible (E_{L}), un ensoleillement moyen (E_{M}) et un ensoleillement fort (E_{H}). L'échelle de temps est identique sur les trois parties a), b) et c).

Comme on le constate sur la figure 5, la charge du dispositif de stockage 30 s'effectue principalement par impulsions, la tension de charge V_{OUT} alternant entre la valeur Vc au cours d'intervalles, désignés par « ON », où le premier régulateur de tension 240 est activé, et la valeur nulle au cours d'intervalles, désignés par « OFF », où ledit premier régulateur de tension est désactivé.

On constate également que plus l'ensoleillement est fort et plus la durée des intervalles OFF diminue. Cela est dû au fait que le panneau solaire 10 génère davantage d'énergie électrique, de sorte que le condensateur 230 se charge plus rapidement et de sorte la tension V_{PV} passe plus rapidement de la valeur limite inférieure V1 à la valeur limite supérieure V2.

On constate en outre que plus l'ensoleillement est fort et plus la durée des intervalles ON augmente. Cela est dû au fait que l'énergie générée par le panneau solaire 10 pendant les intervalles ON contribue à ralentir la décharge du condensateur 230.

La figure 6 représente des résultats expérimentaux illustrant l'évolution de la tension, désignée par VA, aux bornes d'un dispositif de stockage chargé par un panneau solaire.

Plus particulièrement, la figure 6 représente deux courbes :
- une première courbe (en traits discontinus) obtenue avec un système AA selon l'art antérieur, dans lequel le dispositif de stockage est chargé par un panneau solaire par l'intermédiaire uniquement d'un régulateur de tension,
- une seconde courbe (en trait continu) obtenue avec un système INV selon l'invention, comportant un panneau solaire, un dispositif de stockage et un régulateur de tension identiques à ceux du système AA, auxquels on a ajouté un condensateur 230 (accumulateur intermédiaire) ainsi qu'un module de commande 25 qui active/désactive le régulateur de tension en fonction de la valeur de la tension aux bornes du condensateur 230.

Dans la figure 6, les dispositifs de stockage des deux systèmes AA et INV ont été préalablement déchargés jusqu'à ce que la tension VA chute en dessous de 3.3 Volts. Ensuite les dispositifs de stockage des deux systèmes AA et INV ont été chargés entre environ 7h00 du matin et 9h00 du matin, c'est dans des conditions d'ensoleillement faible.

On constate que le dispositif de stockage 30 du système INV selon l'invention commence à se charger bien avant celui du système AA de l'art antérieur, démontrant les avantages liés à l'utilisation du dispositif de transfert 20 d'énergie électrique selon l'invention.

La présente invention concerne également un appareil de télémesure, non représenté sur les figures, comportant notamment un capteur adapté à mesurer la valeur d'une grandeur physique prédéfinie, ainsi que des moyens de communiquer des informations relatives aux mesures effectuées à un serveur distant.

En outre, l'appareil de télémesure comporte un système de génération et de stockage d'énergie électrique comportant notamment un générateur 10 électrique, un dispositif de stockage 30 et un dispositif de transfert 20 d'énergie électrique selon l'invention.

Les moyens de communiquer de l'appareil de télémesure peuvent de tout type connu, filaires (Ethernet, USB, etc.) et/ou non filaires (GSM, UMTS, WiFi, WiMax, etc.).

De manière plus générale, la portée de la présente invention ne se limite pas aux modes de réalisation décrits ci-dessus à titre d'exemples non limitatifs, mais s'étend au contraire à toutes les modifications à la portée de l'homme de l'art.

Par exemple, on comprend que l'invention n'est pas limitée à l'utilisation de panneaux solaires, notamment ceux constitués de cellules photovoltaïques à base de silicium monocristallin, de silicium poly-cristallin, ou de silicium amorphe. L'invention s'applique à tout type de générateur électrique comportant une plage de tensions dans laquelle la puissance électrique fournie est optimisée pour l'essentiel des conditions normales de fonctionnement. On peut citer à titre d'exemple non limitatif un générateur thermoélectrique, tel qu'un module Seebeck.

La description ci-avant illustre clairement que par ses différentes caractéristiques et leurs avantages, la présente invention atteint les objectifs qu'elle s'était fixés.

En particulier, on comprend que l'accumulateur intermédiaire 23 permet d'accumuler progressivement l'énergie électrique, même lorsque celle-ci est générée en faible quantité par le générateur 10 électrique et de la stocker temporairement jusqu'à ce qu'elle puisse être transférée efficacement de l'accumulateur intermédiaire 23 vers le dispositif de stockage 30. Ainsi, le dispositif de stockage 30 peut être chargé même lorsque l'énergie générée par le générateur 10 électrique est faible, par exemple en cas d'ensoleillement faible pour un panneau solaire ou un générateur thermoélectrique.

En outre, l'invention permet d'assurer que le générateur 10 électrique fonctionne proche de son point de fonctionnement optimal pour un ensemble de conditions de fonctionnement prédéfinies. En particulier, l'invention permet d'assurer que le générateur 10 électrique fonctionne proche de son point de fonctionnement optimal dans les conditions de fonctionnement les plus défavorables considérées.

De plus, certains modes de réalisation de l'invention comportent peu de composants électriques, et sont particulièrement simples, robustes et peu coûteux à fabriquer, ce qui les rend particulièrement adaptés à être intégrés dans des appareils de télémesure compacts.

## Revendications

1. Système de génération et de stockage d'énergie électrique comportant un générateur (10) d'énergie électrique, un dispositif de stockage (30) d'énergie électrique, et un dispositif de transfert (20) d'énergie électrique intercalé entre le générateur (10) et le dispositif de stockage (30), **caractérisé en ce que** ledit dispositif de transfert comporte :
- un accumulateur intermédiaire (23) connecté directement au générateur (10) et adapté à stocker de l'énergie électrique reçue dudit générateur,
- des moyens de connexion (24) adaptés à être placés dans au moins deux états : un état connecté dans lequel l'accumulateur intermédiaire (23) se décharge vers le dispositif de stockage (30), et un état déconnecté dans lequel l'accumulateur intermédiaire (23) ne se décharge pas vers ledit dispositif de stockage (30),
- un module de commande (25) configuré pour placer les moyens de connexion (24) dans l'état connecté lorsque la valeur absolue d'une tension électrique (V_{PV}) aux bornes du générateur (10) atteint une valeur limite supérieure (V2) prédéfinie, et pour placer les moyens de connexion (24) dans l'état déconnecté lorsque la valeur absolue de la tension électrique aux bornes dudit générateur atteint une valeur limite inférieure (V1) prédéfinie.

2. Système selon la revendication 1, **caractérisé en ce que**, le générateur (10) étant du type fournissant, pour un ensemble prédéfini de conditions de fonctionnement dudit générateur, une puissance électrique qui croît avec la tension électrique aux bornes dudit générateur jusqu'à atteindre une valeur maximale, puis décroît jusqu'à atteindre une valeur nulle, la valeur limite supérieure (V2) et la valeur limite inférieure (V1) sont telles que la puissance électrique fournie par le générateur est proche de la puissance électrique maximale pour chacune des conditions de fonctionnement dudit ensemble prédéfini de conditions de fonctionnement.

3. Système selon la revendication 2, **caractérisé en ce que**, l'ensemble prédéfini de conditions de fonctionnement comportant des conditions de fonctionnement défavorables et des conditions de fonctionnement favorables en termes de puissance électrique fournie par ledit générateur, la puissance électrique maximale pour les conditions de fonctionnement défavorables est obtenue pour une valeur de la tension électrique, aux bornes dudit générateur, comprise entre la valeur limite supérieure (V2) et la valeur limite inférieure (V1).

4. Système selon l'une des revendications précédentes, **caractérisé en ce que** le module de commande (25) comporte un circuit suiveur (250) à amplificateur opérationnel et un circuit comparateur (251) à deux seuils à amplificateur opérationnel, les deux seuils correspondant respectivement à la valeur limite inférieure (V1) et à la valeur limite supérieure (V2).

5. Système selon l'une des revendications précédentes, **caractérisé en ce que** l'accumulateur intermédiaire (23) comporte un condensateur (230) et/ou un super-condensateur.

6. Système selon l'une des revendications précédentes, **caractérisé en ce qu'il** comporte un premier régulateur de tension (240) adapté à appliquer une tension de valeur sensiblement constante aux bornes du dispositif de stockage (30) lorsque les moyens de connexion (24) sont dans l'état connecté.

7. Système selon la revendication 6, **caractérisé en ce que** les moyens de connexion (24) comportent le premier régulateur de tension (240), le module commande (25) activant ledit premier régulateur de tension pour placer les moyens de connexion (24) dans l'état connecté, et désactivant ledit premier régulateur de tension pour placer lesdits moyens de connexion dans l'état déconnecté.

8. Système selon l'une des revendications précédentes, **caractérisé en ce qu'il** comporte un second régulateur de tension (26) dont l'entrée est couplée aux bornes du générateur (10), et dont la sortie est couplée à un port d'alimentation (ALIM) du module de commande (25).

9. Système selon l'une des revendications précédentes, **caractérisé en ce que** le générateur (10) comporte un panneau solaire et/ou un module Seebeck.

10. Appareil de télémesure comportant un ou plusieurs capteurs adaptés à mesurer la valeur d'une grandeur physique prédéfinie et des moyens de communiquer à un serveur distant des informations relatives aux mesures effectuées, **caractérisé en ce qu'il** comporte un système de génération et de stockage d'énergie électrique conforme à l'une quelconque des revendications précédentes.
